# EUROPEAN PATENT APPLICATION

(11) **EP 1 225 597 A1**
(43) Date of publication of application: **24.07.2002**
(21) Application number: 01830016.0
(22) Date of filing: 15.01.2001
(51) Int. Cl.: G11C 16/32, G11C 7/22

(54) **Synchronous-reading nonvolatile memory**

(71) Applicant: STMicroelectronics S.r.l., 20041 Agrate Brianza MI (IT)
(72) Inventor: Frulio, Massimiliano, 20133 Milano (IT); Villa, Corrado, 20050 Sovico (IT); Bartoli, Simone, 20040 Cambiago (IT)
(74) Representative: Cerbaro, Elena, Dr.

(57) **Abstract**

Described herein is a nonvolatile memory (10) comprising an input pin (2) receiving an external clock signal (CK_{EST}) supplied by a user; an input buffer (4) receiving the external clock signal (CK_{EST}) and supplying an intermediate clock signal (CK_{INT1}) delayed with respect to the external clock signal (CK_{EST}); and a delay locked loop (12) receiving the intermediate clock signal (CK_{INT1}) and supplying an internal clock signal (CK_{INT}) distributed within the nonvolatile memory (10) and substantially in phase with the external clock signal (CK_{EST}).

## Description

The present invention relates to a synchronous-reading nonvolatile memory.

As is known, to meet the continuous demands for increase in reading performance of Flash-EEPROM memories, new modes of reading have been introduced, which were already used in other types of memories, such as DRAM and SRAM memories, in particular the so-called "page mode" reading, in which the memory is read in pages each of which contains a variable number of words, and the so-called "burst mode" reading, in which, instead, synchronous readings of consecutive words are performed at a frequency set by a clock signal supplied from outside by the user of the memory.

Thanks to the fact that the burst reading mode enables a flow of data synchronous with the clock signal, it is increasingly more often implemented in flash-EEPROM memories, even though it does not allow extremely high reading frequencies to be achieved.

In fact, if T_{CK} indicates the period of the external clock signal, T_{BURST} the synchronous access time defined as the time interval elapsing between the edge of the external clock signal representing the request for supply of data on the output of the memory and the instant in time in which the data are effectively present on the output of the memory, and T_{SETUP} the time for setup of the data at the output with respect to the subsequent edge of the clock signal at which the output data will be sampled and acquired from outside the memory (i.e., the minimum time for which the data present on the output of the memory must remain stable prior to the edge of the external clock signal for the data to be sampled and acquired in a valid way, for example by the microprocessor to which the nonvolatile memory is associated), then the following relation applies T_{CK} = T_{BURST} + T_{SETUP}.

Consequently, given that in flash-EEPROM memories according to the prior art operating in burst mode the data setup time T_{SETUP} is, according to the design specification currently adopted, approximately 5 ns, and the synchronous access time T_{BURST} currently achievable is approximately 10 ns, it may immediately be concluded that a reading frequency of approximately 66 MHz (T_{CK} = 15 ns) represents an upper limit that cannot be exceeded in flash-EEPROM memories according to the prior art.

The value of the reading frequency indicated above is then a theoretical limit that is practically not achievable in any of the applications in which nonvolatile memories are supplied with low supply voltages, in particular voltages lower than 1.8 V.

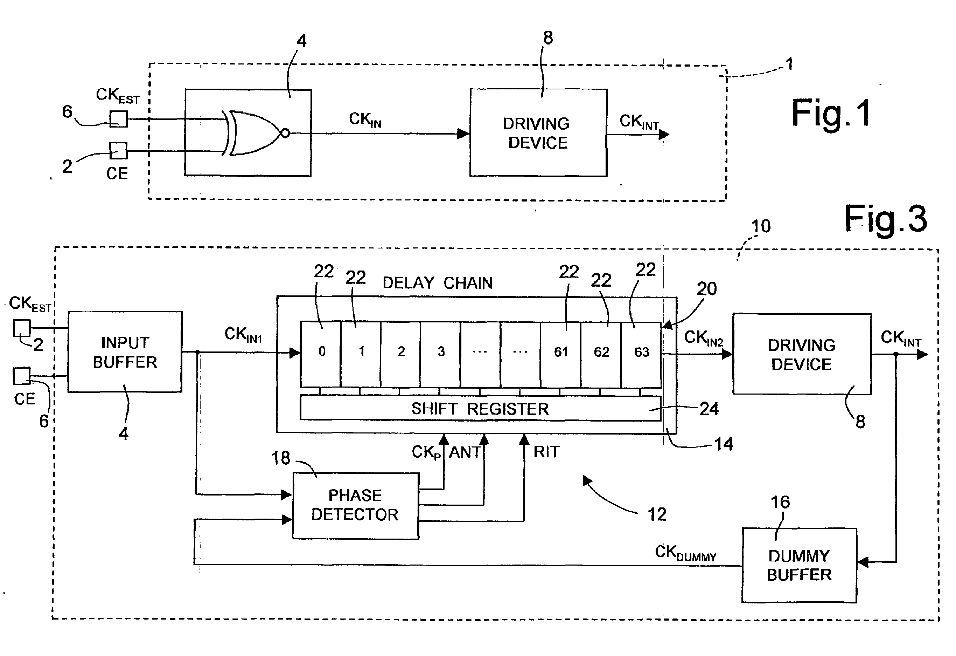

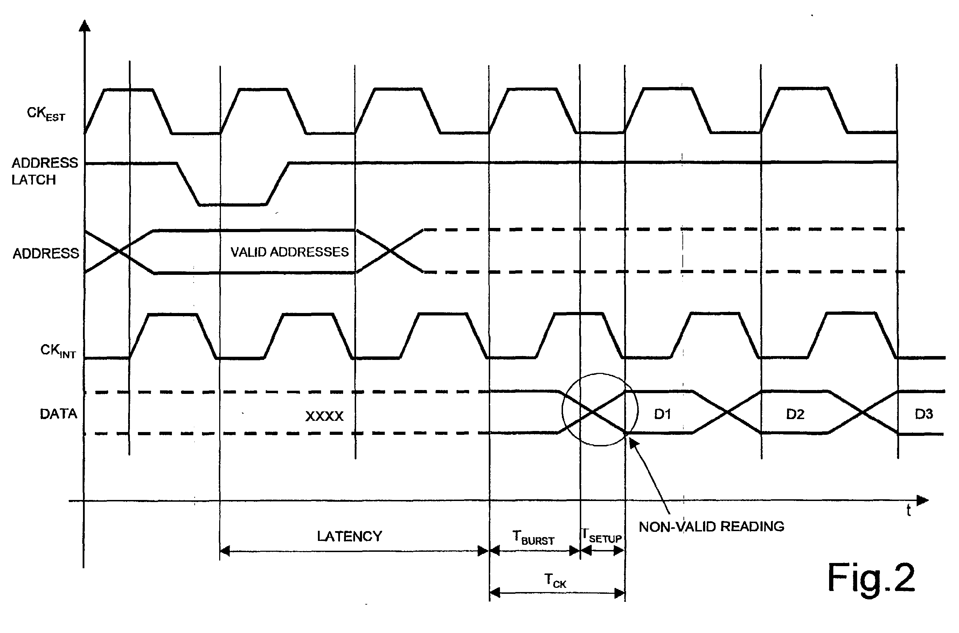

For a better understanding of what has just been described, Figures 1 and 2 respectively show the path followed in a nonvolatile memory according to the prior art by the external clock signal supplied by the user, and the time relation existing between the external clock signal and the clock signal generated inside the memory itself, in relation to the transitions of the data present on the outputs of the memory.

In particular, as is shown in Figure 1, where only the parts of the nonvolatile memory 1 useful for understanding the problems that the present invention aims at solving are illustrated, the external clock signal CK_{EST} is supplied by the user on an input pin 2 of the memory 1, which is connected to an input buffer 4 essentially consisting of a NOR logic gate that has a first input receiving the external clock signal CK_{EST}, a second input receiving a chip enable signal CE, also supplied by the user on a different input pin 6 of the memory 1, and an output supplying an intermediate clock signal CK_{IN}.

The intermediate clock signal CK_{IN} is then supplied to an input of a driving device 8, which supplies on an output an internal clock signal CK_{INT} which is then distributed inside the memory 1 and hence represents the clock signal effectively used by all the devices inside the memory, and with respect to which all the operations are timed.

In particular, the internal clock signal CK_{INT} is delayed with respect to the external clock signal CK_{EST} by a time equal to the sum of the switching time of the input buffer 4 and the switching time of the driving device 8.

From the above it is therefore immediately understandable that the synchronous access time T_{BURST} is the sum of two contributions, the first contribution consisting of the delay between the external clock signal CK_{EST} and the internal clock signal CK_{INT} (typically quantifiable at approximately 5 ns), and the second contribution consisting of the delay with which the data are effectively present on the outputs of the memory 1 with respect to the rising edge of the internal clock signal CK_{INT}, which represents the request for supplying data on the outputs of the memory 1 (also the latter delay being typically quantifiable at approximately 5 ns).

Figure 2 shows the time relation existing between the external clock signal CK_{EST}, the internal clock signal CK_{INT}, and the transitions of the data to be read on the outputs of the memory 1, with reference to a non-valid reading condition caused by failure to comply with the design specification that is commonly adopted for the time of setup of the output data with respect to the next rising edge of the external clock signal at which the said data are sampled and acquired from outside the memory 1.

In particular, in burst mode reading, start of reading of the data is controlled, as is known, by causing variation of the logic level of a control signal "ADDRESS LATCH" supplied by the user to an input of the memory.

In detail, when the start reading control signal "ADDRESS LATCH" assumes a low level, the "ADDRESSES" of the "DATA" to be read supplied by the user to the input of the memory 1 are acquired, and, during a pre-set time interval referred to as "latency", the data are read by the memory cells, temporarily transferred into internal registers of the memory 1, and from the latter then transferred onto the outputs of the memory 1 itself, where they are ready to be sampled and acquired from outside the memory 1 in a synchronous way at the rising edges of the external clock signal CK_{EST}.

In particular, the latency time is indicated by the manufacturer in the specifications of the nonvolatile memory as a function of the frequency of the external clock signal CK_{EST} (in so far as it is tied by the random access time), it can be set externally by the user, and may typically be varied from a minimum of two to a maximum of six periods of the external clock signal CK_{EST}.

Consequently, since the data to be read are supplied on the outputs of the memory 1 synchronously with the internal clock signal CK_{INT}, but are read from outside synchronously with the external clock signal CK_{EST}, they are not stable at the output for at least a time interval equal to the data setup time T_{SETUP} (5 ns) prior to the next edge of the external clock signal CK_{EST} at which the output data are sampled, so that reading of the data does not prove valid.

In order, therefore, to prevent occurrence of non-valid readings, in nonvolatile memories according to the prior art the maximum reading frequency achievable cannot exceed the 66 MHz referred to above, and this constitutes a limitation that slows down fast diffusion of the burst reading mode in flash-EEPROM memories.

The aim of the present invention is to provide a nonvolatile memory operating in burst reading mode that enables synchronous reading of the data stored therein at frequencies higher than those currently achievable.

According to the present invention a nonvolatile memory is provided, as defined in Claim 1.

For a better understanding of the present invention, a preferred embodiment thereof is now described, purely to provide a non-limiting example, with reference to the attached drawings, in which:
- Figure 1 shows the path of the external clock signal supplied by the user in a nonvolatile memory according to the prior art;
- Figure 2 shows the time relation existing, in a nonvolatile memory according to the prior art, between the external clock signal supplied by the user of the memory and the clock signal used inside the memory itself in relation to the transitions of the data present on the output of the memory;
- Figure 3 shows the path of the external clock signal supplied by the user in a nonvolatile memory according to the present invention; and
- Figure 4 shows the time relation existing, in a nonvolatile memory according to the present invention, between the external clock signal supplied by the user of the memory and the clock signal used inside the memory itself in relation to the transitions of the data present on the output of the memory.

The present invention is based upon the principle of increasing the maximum frequency of data reading in a flash-EEPROM nonvolatile memory by eliminating the delay of the internal clock signal CK_{INT} with respect to the external clock signal CK_{EST}; the reduction in the synchronous access time T_{BURST} deriving therefrom makes it possible to achieve reading frequencies in the region of 90-100 MHz.

In greater detail, according to the present invention, elimination of the delay of the internal clock signal CK_{INT} with respect to the external clock signal CK_{EST} is obtained using a delay locked loop (DLL) architecture, in which the periodicity of the external clock signal CK_{EST} is exploited to generate an internal clock signal CK_{INT}, which may even be perfectly in phase with the external clock signal CK_{EST}.

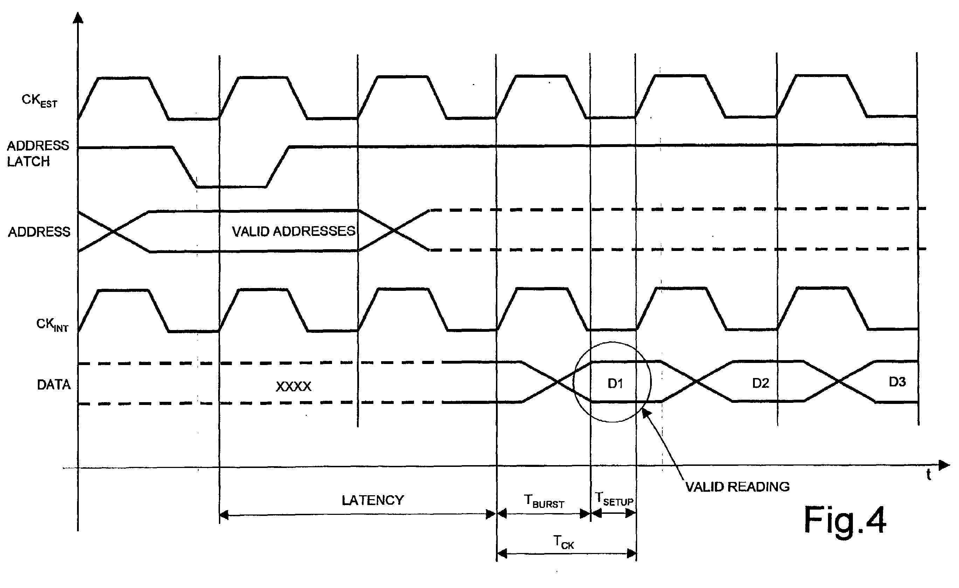

Figure 3 shows a flash-EEPROM nonvolatile memory having a DLL architecture which enables generation of an internal clock signal CK_{INT} in phase with the external clock signal CK_{EST}.

In particular, Figure 3 shows only the parts of the nonvolatile memory, which is designated by 10, that are useful for an understanding of the present invention; in addition, the parts that are identical to those of Figure 1 are designated by the same reference numbers.

In particular, as is shown in Figure 3, the external clock signal CK_{EST} is supplied to an input buffer 4 identical to the one described with reference to Figure 1, which generates on an output a first intermediate clock signal CK_{IN1}.

The first intermediate clock signal CK_{IN1} is then supplied to an input of a delay locked loop 12 basically comprising a programmable delay circuit 14, a driving device 8, a dummy buffer 16, and a phase detector 18.

In particular, the programmable delay circuit 14 receives on an inputs the first intermediate clock signal CK_{IN1}, supplies on an output a second intermediate clock signal CK_{IN2} delayed with respect to the first intermediate clock signal CK_{IN1} by a programmable delay, and comprises a delay chain 20 formed by a plurality of delay cells 22 cascaded together and selectively activatable/deactivatable by a shift register 24 having the function of selecting the delay introduced by the delay chain 20.

In the example shown, the delay chain 20 is formed by 64 delay cells 22, each of which basically consists of two logic inverters cascaded together (for example, obtained by means of NAND logic gates that are selectively activatable/deactivatable by means of an enabling/disabling signal supplied to the inputs of said gates) and conveniently introduces a delay of 0.5 ns.

The second intermediate clock signal CK_{IN2} is supplied to the input of the driving device 8, which is identical to the driving device 1 of Figure 1 and supplies on an output an internal clock signal CK_{INT} which is then distributed inside the memory 10, and which hence represents the clock signal which is used by all the devices present inside the memory and with respect to which all the operations are timed.

The internal clock signal CK_{INT} is moreover supplied to the input of the dummy buffer 16, which is altogether identical to the input buffer 4 in order to simulate the switching delay introduced by the input buffer 4, and supplies on an output a dummy clock signal CK_{DUMMY}.

The dummy clock signal CK_{DUMMY} is then supplied to a first input of the phase detector 18, which moreover receives, on a second input, the first intermediate clock signal CK_{IN1}, determines the phase shift existing between the internal clock signal CK_{INT} and the first intermediate clock signal CK_{IN1}, and then supplies on the outputs the following three signals, which are in turn supplied to the inputs of the shift register 24 of the programmable delay circuit 14: a clock signal CK_{P} for timing the operation of the shift register 24 itself, a delay control signal RIT to increase the delay introduced by the delay chain 20, and an advance control signal ANT to reduce the delay introduced by the delay chain 20.

The shift register 24 moreover has a plurality of outputs, each of which is connected to a respective delay cell 22 to control activation and deactivation thereof as a function of the delay control signal RIT and of the advance control signal ANT.

In particular, the delay control signal RIT and the advance control signal ANT are pulse-type signals, the pulses of which respectively control increase and reduction of the delay introduced by the delay chain 20 in order to bring the internal clock signal CK_{INT} perfectly in phase with the external clock signal CK_{EST}.

In addition, the delay of the first intermediate clock signal CK_{IN1} may be obtained in a simple way by exploiting the structure of the delay cells 22. In fact, since each of these cells is formed by two NAND logic gates cascaded together and selectively activatable by means of an appropriate enabling/disabling signal supplied to the inputs thereof, the first intermediate clock signal CK_{IN1} can conveniently be supplied to the input of all the delay cells 22, and its effective injection within the delay chain 20 can be obtained only at a specific delay cell 22, in such a way that the delay introduced by the delay chain 20 between said specific delay cell 22 and the last delay cell 22 of the chain is precisely the desired one.

In this way, then, the selection of the number of delay cells 22 to be activated in order to achieve the desired delay can be obtained by the shift register 24 simply by issuing a command for disabling the delay cells 22 located upstream of the specific delay cell 22 that determines injection of the first intermediate clock signal CK_{IN1} within the delay chain 20, in such a way that the delay cells 22 located upstream are non-passing with respect to the injection of the first intermediate clock signal CK_{IN1} supplied to the inputs thereof, thus preventing, among other things, unnecessary consumption by elements that are not used, whilst the delay cells 22 located downstream of the specific delay cell 22 that determines injection of the first intermediate clock signal CK_{IN1} within the delay chain 20 are controlled in such a way as to be passing with respect to the clock signal coming from the preceding delay cell and non-passing with respect to the first intermediate clock signal CK_{IN1}.

In use, in a cyclic way the phase detector 18 determines the phase shift existing between the dummy clock signal CK_{DUMMY} and the first intermediate clock signal CK_{IN1} and generates a delay control signal RIT or an advance control signal ANT to control the shift register 24 in such a way as to increase or decrease the number of delay cells 22 activated, in order to obtain an overall delay of the delay chain 20 such as to reduce the phase shift between the dummy clock signal CK_{DUMMY} and the first intermediate clock signal CK_{IN1}, and these operations continue to be performed until the dummy clock signal CK_{DUMMY} is delayed with respect to the first intermediate clock signal CK_{IN1} exactly by one period of the first intermediate clock signal CK_{IN1} itself, and consequently is perfectly in phase with the latter.

Since the first intermediate clock signal CK_{IN1} is constituted by the external clock signal CK_{EST} delayed by an amount equal to the switching time of the input buffer 4, and the dummy clock signal CK_{DUMMY} is constituted by the internal clock signal CK_{INT} delayed by an amount equal to the switching time of the dummy buffer 16, there corresponds to the elimination of the phase shift between the dummy clock signal CK_{DUMMY} and the first intermediate clock signal CK_{IN1} the elimination of the phase shift existing between the internal clock signal CK_{INT} and the external clock signal CK_{EST}.

Consequently, once the so-called locking time necessary for the delay locked loop 12 for eliminating the phase shift existing between the internal clock signal CK_{INT} and the external clock signal CK_{EST} has elapsed, the internal clock signal CK_{INT} is perfectly in phase with the external clock signal CK_{EST}; in this way, one of the contributions to the formation of the synchronous access time T_{BURST} is eliminated, and it is therefore possible to increase the maximum reading frequency up to the values referred to previously.

Figure 4 shows a graph similar to that of Figure 2, from which it is possible to see clearly the elimination of the phase shift existing between internal clock signal CK_{INT} and the external clock signal CK_{EST}, and the valid reading deriving therefrom.

When a DLL architecture is used for generating the internal clock signal CK_{INT}, the user of the memory 10 simply needs to supply the external clock signal CK_{EST} with an advance sufficient to enable the DLL to lock in phase with the external clock signal CK_{EST} itself.

Alternatively, locking may be achieved during a self-learning step prior to data reading, which may be activated by means of an appropriate control signal, and during which the external clock signal CK_{EST} is supplied to the memory 10 in such a way as to set previously the delay introduced by the programmable delay circuit. With this modality, it simply remains for the user to supply to the memory 10 the external clock signal CK_{EST} with an advance of a single period, since locking of the delay locked loop 12 has already taken place.

For example, the command for activation of the self-learning step could be issued immediately after power-on of the memory 10, and in this way the delay locked loop 12 will no longer need to be re-locked in phase with the external clock signal, in so far as any possible temperature variations will be eliminated without the lock command having to be issued again.

The advantages that the present invention affords emerge clearly from an examination of the characteristics presented herein.

Finally, it is clear that modifications and variations may be made to the invention described and illustrated herein, without thereby departing from the sphere of protection, as defined in the attached claims.

For example, the number of delay cells 22 of the delay chain 20 and their corresponding delay could be different from what is described herein, in so far as their number and delay obviously depend upon the range of reading frequencies that it is aimed to cover, as well as upon the delay that it is to be recovered.

## Claims

1. A nonvolatile memory (10) comprising an input (2) receiving an external clock signal (CK_{EST}) supplied by a user, and clock generating means (4, 8, 12) receiving said external clock signal (CK_{EST}) and supplying an internal clock signal (CK_{INT}) distributed into said nonvolatile memory (10); **characterized in that** said clock generating means (4, 8, 12) comprise delay locked loop means (12).

2. The nonvolatile memory according to Claim 1, **characterized in that** said clock generating means (4, 8, 12) further comprise input means (4) arranged between said input (2) of said nonvolatile memory (10) and said delay locked loop means (12); and **in that** said delay locked loop means (12) comprise programmable delay means (14) having a first input connected to said output of said input means (4) and an output supplying said internal clock signal (CK_{INT}), said programmable delay means (14) moreover having a second input receiving a selection signal (RIT, ANT) for selecting a delay introduced by said programmable delay means (14) such as to bring said internal clock signal (CK_{INT}) substantially in phase with said external clock signal (CK_{EST}).

3. The nonvolatile memory according to Claim 2, **characterized in that** said programmable delay means (14) comprise a delay chain (20), and selection means (18, 24) connected to said delay chain (20) and receiving on an input said selection signal (RIT, ANT) for selecting the delay introduced by the delay chain (20).

4. The nonvolatile memory according to Claim 3, **characterized in that** said delay chain (20) is formed by a plurality of delay cells (22) cascaded together.

5. The nonvolatile memory according to Claim 4, **characterized in that** said selection means (18, 24) comprise a shift register (24) connected to said delay cells (22) for activating/deactivating the delay cells (22).

6. The nonvolatile memory according to any of Claims 2 to 5, **characterized in that** said delay locked loop means (12) further comprise phase detecting means (18) receiving on a first input said external clock signal (CK_{EST}) and on a second input said internal clock signal (CK_{INT}), and supplying on an output said selection signal (RIT, ANT) for said programmable delay means (14), said selection signal (RIT, ANT) being a function of the phase shift between said external clock signal (CK_{EST}) and said internal clock signal (CK_{INT}).

7. The nonvolatile memory according to Claim 6, **characterized in that** said first input of said phase detecting means (18) is connected to the output of said input means (4); and **in that** said delay locked loop means (12) further comprise dummy means (16) arranged between the output of said programmable delay means (14) and said second input of said phase detecting means (18) for simulating the delay introduced by said input means (4).

8. The nonvolatile memory according to Claim 7, **characterized in that** said input means comprise an input buffer (4), and said dummy means comprise a dummy buffer (16).

9. The nonvolatile memory according to any of Claims 2 to 8, **characterized in that** said delay locked loop means (12) further comprise driving means (8) connected to the output of said programmable delay means (14).
